# EUROPEAN PATENT APPLICATION

(11) **EP 4 411 827 A1**
(43) Date of publication of application: **07.08.2024**
(21) Application number: 21961795.8
(22) Date of filing: 28.10.2021
(51) Int. Cl.: H01L 29/778

(54) **INTEGRATED CIRCUIT AND METHOD FOR PREPARING SAME, AND POWER AMPLIFIER AND ELECTRONIC DEVICE**

(71) Applicant: Huawei Technologies Co., Ltd., Shenzhen, Guangdong 518129 (CN)
(72) Inventor: HU, Bin, Shenzhen, Guangdong 518129 (CN); DUAN, Huantao, Shenzhen, Guangdong 518129 (CN); NI, Ruxue, Shenzhen, Guangdong 518129 (CN); ZHU, Min, Shenzhen, Guangdong 518129 (CN)
(74) Representative: Isarpatent
(86) International application number: PCT/CN2021/126984
(87) International publication number: WO 2023/070428

(57) **Abstract**

An integrated circuit, a manufacturing method thereof, a power amplifier, and an electronic device are provided. The integrated circuit includes: a substrate (1), a first nucleation layer (2) located on the substrate (1), a buffer layer (3) located on the first nucleation layer (2), a channel layer (4) located on the buffer layer (3), a barrier layer (5) located on the channel layer (4), and a source (6), a drain (7), and a gate (8) that are separately located on the barrier layer (5). A dislocation density of the buffer layer (3) is less than 1e8 cm⁻², so that crystalline quality can be improved, and a higher-quality epitaxial growth material can be obtained, to improve device performance and long-term reliability of the integrated circuit.

## Description

### TECHNICAL FIELD

This application relates to the field of semiconductor technologies, and in particular, to an integrated circuit, a manufacturing method thereof, a power amplifier, and an electronic device.

### BACKGROUND

Usually, for an integrated circuit obtained through heteroepitaxial growth on a hetero substrate based on a metal organic chemical vapor deposition (Metal organic Chemical Vapor Deposition, MOCVD) method, performance and reliability of the integrated circuit need to be improved.

### SUMMARY

This application provides an integrated circuit, a manufacturing method thereof, a power amplifier, and an electronic device, to improve performance and reliability.

According to a first aspect, this application provides an integrated circuit, including: a substrate 1, a first nucleation layer located on the substrate, a buffer layer located on the first nucleation layer, a channel layer located on the buffer layer, a barrier layer located on the channel layer, and a source, a drain, and a gate that are separately located on the barrier layer. A dislocation density of the buffer layer is less than 1e8 cm⁻². Specifically, the integrated circuit may be a high electron mobility transistor (High Electron Mobility Transistor, HEMT).

In the integrated circuit provided in this embodiment of this application, the dislocation density of the buffer layer is less than 1e8 cm⁻², so that crystalline quality can be improved, and a higher-quality epitaxial growth material can be obtained, to improve device performance and long-term reliability of the integrated circuit.

In a possible implementation of this application, the dislocation density of the buffer layer may be further controlled to be less than 1e6 cm⁻², so that crystalline quality can be further improved, and a higher-quality epitaxial growth material can be obtained, to improve device performance and long-term reliability of the integrated circuit.

In a possible implementation of this application, a lattice mismatch between the first nucleation layer and the buffer layer may be controlled to be less than 2%, so that crystalline quality can be improved, and a higher-quality epitaxial growth material can be obtained, to improve device performance and long-term reliability of the integrated circuit.

In a possible implementation of this application, the buffer layer may include doped GaN or doped AlGaN, and the first nucleation layer may include an AlScN material, an AlInN material, or the like. A doping material of the buffer layer may be Fe, C, or the like, and resistivity of the buffer layer may be improved by doping Fe or C. When the first nucleation layer uses the AlScN material, Sc atoms in AlScN may increase an atomic spacing between Al and N, and increase a lattice constant, to implement a good lattice match with the GaN material and achieve a minimum lattice mismatch. Similarly, in this application, when the first nucleation layer uses the AlInN material, In atoms in AlInN may increase an atomic spacing between Al and N, and increase a lattice constant, to implement a good lattice match with the GaN material and achieve a minimum lattice mismatch. In addition, specifically, a percentage of Sc or In in the material of the first nucleation layer may be adjusted, to implement the good lattice match with the GaN material and achieve the minimum lattice mismatch.

In a possible implementation of this application, an atomic percentage of Sc or In in the first nucleation layer is usually less than 40%, so that the lattice mismatch between the first nucleation layer and the buffer layer may be less than 2%. In addition, as the percentage of Sc or In in the first nucleation layer gradually increases from 0%, a lattice mismatch with GaN gradually decreases.

In a possible implementation of this application, the atomic percentage of Sc or In in the first nucleation layer may range from 15% to 20%. Specifically, when the atomic percentage of Sc in the first nucleation layer reaches 18.75%, that is, Al_{0.8125}Sc_{0.1875}N, a lattice of the AlScN material and a lattice of the GaN material completely match, and a mismatch between atoms is the smallest. When the atomic percentage of In in the first nucleation layer reaches 17%, that is, Al_{0.83}In_{0.17}N, a lattice of the AlInN material and the lattice of the GaN material completely match, and a mismatch between atoms is the smallest.

In a possible implementation of this application, when the first nucleation layer is manufactured by using AlScN or AlInN, the first nucleation layer may be specifically manufactured through a PVD or PLD process. In comparison with a case in which AlN is manufactured as a nucleation layer through a MOCVD process, the first nucleation layer manufactured through the PVD and PLD processes has less selectivity on the substrate, that is, a requirement on quality of the substrate is reduced, so that growth of a material of the subsequent channel layer does not depend on the substrate. The first nucleation layer may be obtained through deposition on the slightly-poor-quality or ordinary-quality substrate. The obtained first nucleation layer may be used to directly grow the doped GaN material as the buffer layer, and then a high-quality GaN material may be epitaxially grown on the basis of the buffer layer as the channel layer. Therefore, the substrate may directly use a SiC or Si material, so that high-quality GaN epitaxial growth can also be implemented on the Si substrate with a large lattice mismatch.

In a possible implementation of this application, when the substrate uses the SiC material, in comparison with the case in which the first nucleation layer uses the AlScN material, the AlInN material, or the like, a lattice constant of SiC is closer to a lattice constant of AlN. Therefore, atomic percentages of Sc or In at different locations in the first nucleation layer may be adjusted, to be specific, an atomic percentage of Sc or In in a surface that is of the first nucleation layer and that is in contact with the substrate is adjusted to be less than an atomic percentage of Sc or In in a surface that is of the first nucleation layer and that is in contact with the buffer layer, so that a lattice constant of the surface that is of the first nucleation layer and that is in contact with the substrate is less than a lattice constant of the surface that is of the first nucleation layer and that is in contact with the buffer layer. In this way, the lattice constant of the surface that is of the first nucleation layer and that is in contact with the substrate is closer to the lattice constant of SiC, so that a lattice match in a contact interface between the first nucleation layer and the substrate is better; and the lattice constant of the surface that is of the first nucleation layer and that is in contact with the buffer layer is closer to a lattice constant of the buffer layer, so that a lattice match in a contact interface between the first nucleation layer and the buffer layer is better, to reduce lattice defects of the first nucleation layer and the buffer layer, and improve crystalline quality.

In a possible implementation of this application, when the first nucleation layer uses the AlScN material or the like, the atomic percentage of Sc in the first nucleation layer may change from 0% to 18%, so that the first nucleation layer is used as a gradient layer. A material of a surface that is of the gradient layer and that is in contact with the substrate is AlN, to match a lattice of SiC most. An atomic percentage of Sc in the gradient layer gradually increases. An atomic percentage of Sc in AlScN on a surface that is of the gradient layer and that is in contact with the buffer layer is the largest, to match the lattice of GaN. When the first nucleation layer uses the AlInN material or the like, the atomic percentage of In in the first nucleation layer may change from 0% to 17%, so that the first nucleation layer is used as a gradient layer. A material of a surface that is of the gradient layer and that is in contact with the substrate is AlN, to match a lattice of SiC most. An atomic percentage of In in the gradient layer gradually increases, and an atomic percentage of In in AlInN on a surface that is of the gradient layer and that is in contact with the buffer layer is the largest, to match the lattice of GaN.

In a possible implementation of this application, compared with using the MOCVD process to manufacture the first nucleation layer, using the PVD or PLD process to manufacture the first nucleation layer leads to a high deposition rate during generation of the first nucleation layer, which can save more than 20% production capacity, and significantly reduce production costs. In addition, the PVD or PLD process may support a substrate of 8 inches to 12 inches or more. Specifically, direct sputtering may be performed by using an AlScN or AlInN target, or reactive sputtering may be performed by using an Al target, an Sc target (or an In target), and an ammonia gas or a nitrogen gas, to form the first nucleation layer on the substrate. The atomic percentage of Sc or In in the first nucleation layer formed through the foregoing process may be fixed. Alternatively, when the Al target, the Sc target (or the In target), and the ammonia gas or the nitrogen gas are used to perform reactive sputtering to form the first nucleation layer on the substrate, a reactive sputtering proportion of the Sc target or the In target may be gradually increased, to gradually increase the atomic percentage of Sc or In in the first nucleation layer in a direction from the substrate to the buffer layer, to form the gradient layer. The gradual increase may be understood as a plurality of increase trends, including a linear increase, a stepwise increase, a parabolic increase, and the like. The thick first nucleation layer may be manufactured through the PVD or PLD process, and a thickness of the first nucleation layer may be controlled within 10 nm to 500 nm.

Because the first nucleation layer manufactured through PVD or PLD is made of a polycrystalline material (where the polycrystalline material is made of a plurality of columnar materials, there is a grain boundary between the columnar materials, and the grain boundary forms a defect), the first nucleation layer has a large quantity of grain boundaries, crystalline quality is poor, and crystals are mainly arranged in a vertical direction. Therefore, to improve crystalline quality of the nucleation layer, after the first nucleation layer is manufactured through the PVD or PLD process, a high temperature annealing process may be performed on the first nucleation layer under protection of an inert gas, to improve crystalline quality of the material of the first nucleation layer. Alternatively, to improve crystalline quality of the nucleation layer, after the first nucleation layer is manufactured through the PVD or PLD process, a second nucleation layer may be manufactured through the MOVCD process. The second nucleation layer may be made of a quasi-single crystalline material. In a possible implementation of this application, the integrated circuit may further include the second nucleation layer located between the first nucleation layer and the buffer layer. The second nucleation layer is manufactured through the MOCVD process, so that a quantity of grain boundaries in the second nucleation layer is less than a quantity of grain boundaries in the first nucleation layer. In other words, the second nucleation layer has fewer crystal defects, and crystalline quality is better. In this way, when the buffer layer is epitaxially grown on the second nucleation layer, better crystalline quality can be obtained.

To ensure that the second nucleation layer with good crystalline quality can be obtained, the material used by the second nucleation layer needs to be the same as the material used by the first nucleation layer. For example, after AlScN is deposited on the substrate as the first nucleation layer through the PVD or PLD process, AlScN may continue to be grown as the second nucleation layer through the MOCVD process. In addition, atomic percentages of Sc or In in surfaces that are of the first nucleation layer and the second nucleation layer and that are in contact with each other are preferably the same, so that lattices of the first nucleation layer and the second nucleation layer completely match, and no new lattice defect appears. For example, if the atomic percentage of Sc in the first nucleation layer is 18%, an atomic percentage of Sc in the second nucleation layer is also 18%. For another example, if the atomic percentage of Sc in the first nucleation layer changes from 0% to 18%, the atomic percentage of Sc in the second nucleation layer is 18%. In addition, because a film layer is slowly grown when the MOVCD process is used, a thickness of the second nucleation layer may be thin, and is controlled to be less than 100 nm, to be specific, from several nm to dozens of nm.

In a possible implementation of this application, a surface density of a two-dimensional electron gas formed by using the barrier layer is greater than 1e13 cm⁻², to implement a higher surface density of the two-dimensional electron gas when a thickness of the barrier layer is thin, and facilitate application of a radio frequency HEMT device at a high frequency. Further, the surface density of the two-dimensional electron gas formed by using the barrier layer is greater than 2e13 cm⁻², to further improve the surface density of the two-dimensional electron gas of the barrier layer.

In a possible implementation of this application, the barrier layer may include the AlScN material, the AlInN material, the AlN material, or the like. These materials have good piezoelectric effect, so that a two-dimensional electron gas concentration of the barrier layer can be increased, and device short channel effect that is in a device and that is caused by a decrease in the thickness of the barrier layer can be effectively reduced. In addition, the AlScN or AlInN material is used as the barrier layer, so that a lattice mismatch between the channel layer and the barrier layer can be further reduced, crystalline quality can be improved, and a higher-quality epitaxial growth material can be obtained, to improve device performance and long-term reliability of the integrated circuit. Specifically, when the AlScN or AlInN material is used as the barrier layer, an atomic percentage of Sc or In is the same as the atomic percentage of Sc or In in the first nucleation layer. The atomic percentage is usually less than 40%, and preferably ranges from 15% to 20%, to reduce the lattice mismatch. An optimal atomic percentage of Sc is 18%, and an optimal atomic percentage of In is 17%.

According to a second aspect, this application provides an integrated circuit, including: a substrate 1, a first nucleation layer located on the substrate, a buffer layer located on the first nucleation layer, a channel layer located on the buffer layer, a barrier layer located on the channel layer, and a source, a drain, and a gate that are separately located on the barrier layer. The buffer layer may include doped GaN or doped AlGaN, and the first nucleation layer may include an AlScN material, an AlInN material, or the like. A doping material of the buffer layer may be Fe, C, or the like, and resistivity of the buffer layer may be improved by doping Fe or C. When the first nucleation layer uses the AlScN material, Sc atoms in AlScN may increase an atomic spacing between Al and N, and increase a lattice constant, to implement a good lattice match with the GaN material and achieve a minimum lattice mismatch, so that a dislocation density of the buffer layer is reduced to be less than 1e8 cm⁻², or even less than 1e6 cm⁻². Similarly, in this application, when the first nucleation layer uses the AlInN material, In atoms in AlInN may increase an atomic spacing between Al and N, and increase a lattice constant, to implement a good lattice match with the GaN material and achieve a minimum lattice mismatch. In addition, specifically, a percentage of Sc or In in the material of the first nucleation layer may be adjusted, to implement the good lattice match with the GaN material and achieve the minimum lattice mismatch, so that a dislocation density of the buffer layer is reduced to be less than 1e8 cm⁻², or even less than 1e6 cm⁻². A lattice mismatch between the buffer layer and the first nucleation layer is reduced, and the dislocation density of the buffer layer is reduced, so that crystalline quality can be improved, and a higher-quality epitaxial growth material can be obtained, to improve device performance and long-term reliability of the integrated circuit.

In a possible implementation of this application, an atomic percentage of Sc or In in the first nucleation layer is usually less than 40%, so that the lattice mismatch between the first nucleation layer and the buffer layer may be less than 2%. In addition, as the percentage of Sc or In in the first nucleation layer gradually increases from 0%, a lattice mismatch with GaN gradually decreases.

In a possible implementation of this application, the atomic percentage of Sc or In in the first nucleation layer may range from 15% to 20%. Specifically, when the atomic percentage of Sc in the first nucleation layer reaches 18.75%, that is, Al_{0.8125}Sc_{0.1875}N, a lattice of the AlScN material and a lattice of the GaN material completely match, and a mismatch between atoms is the smallest. When the atomic percentage of In in the first nucleation layer reaches 17%, that is, Al_{0.83}In_{0.17}N, a lattice of the AlInN material and the lattice of the GaN material completely match, and a mismatch between atoms is the smallest.

In a possible implementation of this application, when the first nucleation layer is manufactured by using AlScN or AlInN, the first nucleation layer may be specifically manufactured through a PVD or PLD process. In comparison with a case in which AlN is manufactured as a nucleation layer through a MOCVD process, the first nucleation layer manufactured through the PVD and PLD processes has less selectivity on the substrate, that is, a requirement on quality of the substrate is reduced, so that growth of a material of the subsequent channel layer does not depend on the substrate. The first nucleation layer may be obtained through deposition on the slightly-poor-quality or ordinary-quality substrate. The obtained first nucleation layer may be used to directly grow the doped GaN material as the buffer layer, and then a high-quality GaN material may be epitaxially grown on the basis of the buffer layer as the channel layer. Therefore, the substrate may directly use a SiC or Si material, so that high-quality GaN epitaxial growth can also be implemented on the Si substrate with a large lattice mismatch.

In a possible implementation of this application, when the substrate uses the SiC material, in comparison with the case in which the first nucleation layer uses the AlScN material, the AlInN material, or the like, a lattice constant of SiC is closer to a lattice constant of AlN. Therefore, atomic percentages of Sc or In at different locations in the first nucleation layer may be adjusted, to be specific, an atomic percentage of Sc or In in a surface that is of the first nucleation layer and that is in contact with the substrate is adjusted to be less than an atomic percentage of Sc or In in a surface that is of the first nucleation layer and that is in contact with the buffer layer, so that a lattice constant of the surface that is of the first nucleation layer and that is in contact with the substrate is less than a lattice constant of the surface that is of the first nucleation layer and that is in contact with the buffer layer. In this way, the lattice constant of the surface that is of the first nucleation layer and that is in contact with the substrate is closer to the lattice constant of SiC, so that a lattice match in a contact interface between the first nucleation layer and the substrate is better; and the lattice constant of the surface that is of the first nucleation layer and that is in contact with the buffer layer is closer to a lattice constant of the buffer layer, so that a lattice match in a contact interface between the first nucleation layer and the buffer layer is better, to reduce lattice defects of the first nucleation layer and the buffer layer, and improve crystalline quality.

In a possible implementation of this application, when the first nucleation layer uses the AlScN material or the like, the atomic percentage of Sc in the first nucleation layer may change from 0% to 18%, so that the first nucleation layer is used as a gradient layer. A material of a surface that is of the gradient layer and that is in contact with the substrate is AlN, to match a lattice of SiC most. An atomic percentage of Sc in the gradient layer gradually increases. An atomic percentage of Sc in AlScN on a surface that is of the gradient layer and that is in contact with the buffer layer is the largest, to match the lattice of GaN. When the first nucleation layer uses the AlInN material or the like, the atomic percentage of In in the first nucleation layer may change from 0% to 17%, so that the first nucleation layer is used as a gradient layer. A material of a surface that is of the gradient layer and that is in contact with the substrate is AlN, to match a lattice of SiC most. An atomic percentage of In in the gradient layer gradually increases, and an atomic percentage of In in AlInN on a surface that is of the gradient layer and that is in contact with the buffer layer is the largest, to match the lattice of GaN.

In a possible implementation of this application, compared with using the MOCVD process to manufacture the first nucleation layer, using the PVD or PLD process to manufacture the first nucleation layer leads to a high deposition rate during generation of the first nucleation layer, which can save more than 20% production capacity, and significantly reduce production costs. In addition, the PVD or PLD process may support a substrate of 8 inches to 12 inches or more. Specifically, direct sputtering may be performed by using an AlScN or AlInN target, or reactive sputtering may be performed by using an Al target, an Sc target (or an In target), and an ammonia gas or a nitrogen gas, to form the first nucleation layer on the substrate. The atomic percentage of Sc or In in the first nucleation layer formed through the foregoing process may be fixed. Alternatively, when the Al target, the Sc target (or the In target), and the ammonia gas or the nitrogen gas are used to perform reactive sputtering to form the first nucleation layer on the substrate, a reactive sputtering proportion of the Sc target or the In target may be gradually increased, to gradually increase the atomic percentage of Sc or In in the first nucleation layer in a direction from the substrate to the buffer layer, to form the gradient layer. The gradual increase may be understood as a plurality of increase trends, including a linear increase, a stepwise increase, a parabolic increase, and the like. The thick first nucleation layer may be manufactured through the PVD or PLD process, and a thickness of the first nucleation layer may be controlled within 10 nm to 500 nm.

Because the first nucleation layer manufactured through PVD or PLD is made of a polycrystalline material (where the polycrystalline material is made of a plurality of columnar materials, there is a grain boundary between the columnar materials, and the grain boundary forms a defect), the first nucleation layer has a large quantity of grain boundaries, crystalline quality is poor, and crystals are mainly arranged in a vertical direction. Therefore, to improve crystalline quality of the nucleation layer, after the first nucleation layer is manufactured through the PVD or PLD process, a high temperature annealing process may be performed on the first nucleation layer under protection of an inert gas, to improve crystalline quality of the material of the first nucleation layer. Alternatively, to improve crystalline quality of the nucleation layer, after the first nucleation layer is manufactured through the PVD or PLD process, a second nucleation layer may be manufactured through the MOVCD process. The second nucleation layer may be made of a quasi-single crystalline material. In a possible implementation of this application, the integrated circuit may further include the second nucleation layer located between the first nucleation layer and the buffer layer. The second nucleation layer is manufactured through the MOCVD process, so that a quantity of grain boundaries in the second nucleation layer is less than a quantity of grain boundaries in the first nucleation layer. In other words, the second nucleation layer has fewer crystal defects, and crystalline quality is better. In this way, when the buffer layer is epitaxially grown on the second nucleation layer, better crystalline quality can be obtained.

To ensure that the second nucleation layer with good crystalline quality can be obtained, the material used by the second nucleation layer needs to be the same as the material used by the first nucleation layer. For example, after AlScN is deposited on the substrate as the first nucleation layer through the PVD or PLD process, AlScN may continue to be grown as the second nucleation layer through the MOCVD process. In addition, atomic percentages of Sc or In in surfaces that are of the first nucleation layer and the second nucleation layer and that are in contact with each other are preferably the same, so that lattices of the first nucleation layer and the second nucleation layer completely match, and no new lattice defect appears. For example, if the atomic percentage of Sc in the first nucleation layer is 18%, an atomic percentage of Sc in the second nucleation layer is also 18%. For another example, if the atomic percentage of Sc in the first nucleation layer changes from 0% to 18%, the atomic percentage of Sc in the second nucleation layer is 18%. In addition, because a film layer is slowly grown when the MOVCD process is used, a thickness of the second nucleation layer may be thin, and is controlled to be less than 100 nm, to be specific, from several nm to dozens of nm.

In a possible implementation of this application, a surface density of a two-dimensional electron gas formed by using the barrier layer is greater than 1e13 cm⁻², to implement a higher surface density of the two-dimensional electron gas when a thickness of the barrier layer is thin, and facilitate application of a radio frequency HEMT device at a high frequency. Further, the surface density of the two-dimensional electron gas formed by using barrier layer is greater than 2e13 cm⁻², to further improve the surface density of the two-dimensional electron gas of the barrier layer.

In a possible implementation of this application, the barrier layer may include the AlScN material, the AlInN material, the AlN material, or the like. These materials have good piezoelectric effect, so that a two-dimensional electron gas concentration of the barrier layer can be increased, and device short channel effect that is in a device and that is caused by a decrease in the thickness of the barrier layer can be effectively reduced. In addition, the AlScN or AlInN material is used as the barrier layer, so that a lattice mismatch between the channel layer and the barrier layer can be further reduced, crystalline quality can be improved, and a higher-quality epitaxial growth material can be obtained, to improve device performance and long-term reliability of the integrated circuit. Specifically, when the AlScN or AlInN material is used as the barrier layer, an atomic percentage of Sc or In is the same as the atomic percentage of Sc or In in the first nucleation layer. The atomic percentage is usually less than 40%, and preferably ranges from 15% to 20%, to reduce the lattice mismatch. An optimal atomic percentage of Sc is 18%, and an optimal atomic percentage of In is 17%.

According to a third aspect, this application provides a manufacturing method for the integrated circuit provided in any instance of the first aspect or the second aspect. The method includes: forming a first nucleation layer on a substrate through a physical vapor deposition PVD process or a pulsed laser deposition PLD process; forming a buffer layer on the first nucleation layer through a metal organic chemical vapor deposition MOCVD process; forming a channel layer on the buffer layer through the MOCVD process; forming a barrier layer on the channel layer through the MOCVD process or a molecular beam epitaxy MBE process; and separately forming a source, a drain, and a gate on the barrier layer.

In comparison with a case in which AlN is manufactured as a nucleation layer through the MOCVD process, the first nucleation layer manufactured through the PVD and PLD processes has less selectivity on the substrate, that is, a requirement on quality of the substrate is reduced, so that growth of a material of the subsequent channel layer does not depend on the substrate. The first nucleation layer may be obtained through deposition on the slightly-poor-quality or ordinary-quality substrate. The obtained first nucleation layer may be used to directly grow a doped GaN material as the buffer layer, and then a high-quality GaN material may be epitaxially grown on the basis of the buffer layer as the channel layer. Therefore, the substrate may directly use a SiC or Si material, so that high-quality GaN epitaxial growth can also be implemented on the Si substrate with a large lattice mismatch.

In addition, compared with using the MOCVD process to manufacture the first nucleation layer, using the PVD or PLD process to manufacture the first nucleation layer leads to a high deposition rate during generation of the first nucleation layer, which can save more than 20% production capacity, and significantly reduce production costs. In addition, the PVD or PLD process may support a substrate of 8 inches to 12 inches or more.

In a possible implementation of this application, specifically, direct sputtering may be performed by using an AlScN or AlInN target, or reactive sputtering may be performed by using an Al target, an Sc target (or an In target), and an ammonia gas or a nitrogen gas, to form the first nucleation layer on the substrate 1. An atomic percentage of Sc or In in the first nucleation layer formed through the foregoing process may be fixed. Alternatively, when the Al target, the Sc target (or the In target), and the ammonia gas or the nitrogen gas are used to perform reactive sputtering to form the first nucleation layer on the substrate, a reactive sputtering proportion of the Sc target or the In target may be gradually increased, to gradually increase the atomic percentage of Sc or In in the first nucleation layer in a direction from the substrate to the buffer layer, to form a gradient layer. The thick first nucleation layer may be manufactured through the PVD or PLD process, and a thickness of the first nucleation layer may be controlled within 10 nm to 500 nm.

In a possible implementation of this application, because the first nucleation layer manufactured through PVD or PLD is made of a polycrystalline material, the first nucleation layer has a large quantity of grain boundaries, crystalline quality is poor, and crystals are mainly arranged in a vertical direction. Therefore, to improve crystalline quality of the nucleation layer, after the first nucleation layer is manufactured through the PVD or PLD process, a second nucleation layer may be manufactured through the MOVCD process. The second nucleation layer may be made of a quasi-single crystalline material. A quantity of grain boundaries in the second nucleation layer is less than a quantity of grain boundaries in the first nucleation layer. In other words, the second nucleation layer has fewer crystal defects, and crystalline quality is better. In this way, when the buffer layer is epitaxially grown on the second nucleation layer, better crystalline quality can be obtained.

To ensure that the second nucleation layer with good crystalline quality can be obtained, the material used by the second nucleation layer needs to be the same as the material used by the first nucleation layer. For example, after AlScN is deposited on the substrate as the first nucleation layer through the PVD or PLD process, AlScN may continue to be grown as the second nucleation layer through the MOCVD process. In addition, atomic percentages of Sc or In in surfaces that are of the first nucleation layer and the second nucleation layer and that are in contact with each other are preferably the same, so that lattices of the first nucleation layer and the second nucleation layer completely match, and no new lattice defect appears. For example, if the atomic percentage of Sc in the first nucleation layer is 18%, an atomic percentage of Sc in the second nucleation layer is also 18%. For another example, if the atomic percentage of Sc in the first nucleation layer gradually transits from 0% to 18%, the atomic percentage of Sc in the second nucleation layer is 18%. In addition, because a film layer is slowly grown when the MOVCD process is used, a thickness of the second nucleation layer may be thin, and is controlled to be less than 100 nm, to be specific, from several nm to dozens of nm.

In a possible implementation of this application, after the forming a first nucleation layer on a substrate, a high temperature annealing process may be further performed on the first nucleation layer under protection of an inert gas, to improve crystalline quality of the material of the first nucleation layer. Specifically, an annealing temperature may be controlled within 1500 degrees to 1900 degrees, and preferably, the annealing temperature is controlled within 1600 degrees to 1800 degrees. Annealing duration is within 1 hour to 5 hours, and preferably within 2 hours to 3 hours. The inert gas may be specifically an argon gas or the nitrogen gas.

According to a fourth aspect, an electronic device is provided. The electronic device includes a circuit board and the integrated circuit according to the implementations of the first aspect or the second aspect that is disposed on the circuit board.

According to a fifth aspect, a power amplifier is provided. The power amplifier includes a circuit board and the integrated circuit according to the implementations of the first aspect or the second aspect that is disposed on the circuit board.

For technical effects that may be achieved by any one of the third aspect to the fifth aspect, refer to descriptions of technical effects that may be achieved by any possible design in the first aspect or the second aspect. Details are not described herein again.

### BRIEF DESCRIPTION OF DRAWINGS

FIG. 1a is a schematic diagram of a structure of a depletion-mode HEMT device for radio frequency application;
FIG. 1b is a schematic diagram of a structure of an enhancement-mode HEMT device for power application;
FIG. 2 is a schematic diagram of a lattice mismatch and a thermal mismatch of a heteroepitaxial structure;
FIG. 3a is a schematic diagram of a structure of adding a gradient layer to a heteroepitaxial structure;
FIG. 3b is a schematic diagram of a structure of adding a buffer layer to a heteroepitaxial structure;
FIG. 4 is a schematic diagram of a cross-sectional structure of an integrated circuit according to an embodiment of this application;
FIG. 5a is a comparison diagram of lattice constants between different materials;
FIG. 5b is a schematic diagram of a relationship between a thickness of a first nucleation layer and an atomic percentage of Sc or In in the first nucleation layer;
FIG. 5c is another schematic diagram of a relationship between a thickness of a first nucleation layer and an atomic percentage of Sc or In in the first nucleation layer;
FIG. 5d is a schematic diagram of a structure of a first nucleation layer made of a polycrystalline material;
FIG. 6a is a schematic diagram of a cross-sectional structure of another integrated circuit according to an embodiment of this application;
FIG. 6b is a schematic diagram of a relationship between a thickness of a nucleation layer and an atomic percentage of Sc or In in the nucleation layer;
FIG. 6c is another schematic diagram of a relationship between a thickness of a nucleation layer and an atomic percentage of Sc or In in the nucleation layer;
FIG. 7 is a schematic flowchart of a manufacturing method for an integrated circuit according to an embodiment of this application;
FIG. 8 is a schematic diagram of a structure after each step in the manufacturing method provided in FIG. 7 is completed;
FIG. 9 is a schematic flowchart of another manufacturing method for an integrated circuit according to an embodiment of this application;
FIG. 10 is a schematic diagram of a structure after each step in the manufacturing method provided in FIG. 9 is completed.
FIG. 11 is a schematic flowchart of another manufacturing method for an integrated circuit according to an embodiment of this application; and
FIG. 12 is a schematic diagram of a structure after each step in the manufacturing method provided in FIG. 11 is completed.

### Reference numerals:

1: substrate; 2: first nucleation layer; 3: buffer layer; 4: channel layer; 5: barrier layer; 6: source; 7: drain; 8: gate; 9: second nucleation layer.

### DESCRIPTION OF EMBODIMENTS

To make the objectives, technical solutions, and advantages of this application clearer, the following further describes this application in detail with reference to the accompanying drawings.

A GaN semiconductor material has performance advantages of a wide band gap, a high breakdown field strength, a high polarization coefficient, high electron mobility, a high saturated electron drift velocity, and the like, and has a great application prospect in fields of power electronics and radio frequency. A GaN HEMT device mainly uses two-dimensional electron gas generated due to polarization effect at an AlGaN/GaN heterojunction interface to implement high electron mobility. This device has advantages of a high withstand voltage, a high power density, a high working speed, and the like.

This application may be applied to the field of microelectronics, including a microwave radio frequency device, a power electronic device, and the like, or may be extended to an optoelectronic device or another field of microelectronics. The microwave radio frequency device mainly uses the GaN device as a power amplifier. A function of the power amplifier is to amplify a radio frequency signal inside an active antenna unit (active antenna unit, AAU) of a base station, and then transmit the radio frequency signal through an antenna. The power electronic device mainly uses the GaN device as a power switch, to enable fast charging for a terminal product such as a mobile phone, serve as a switch of lidar, and the like.

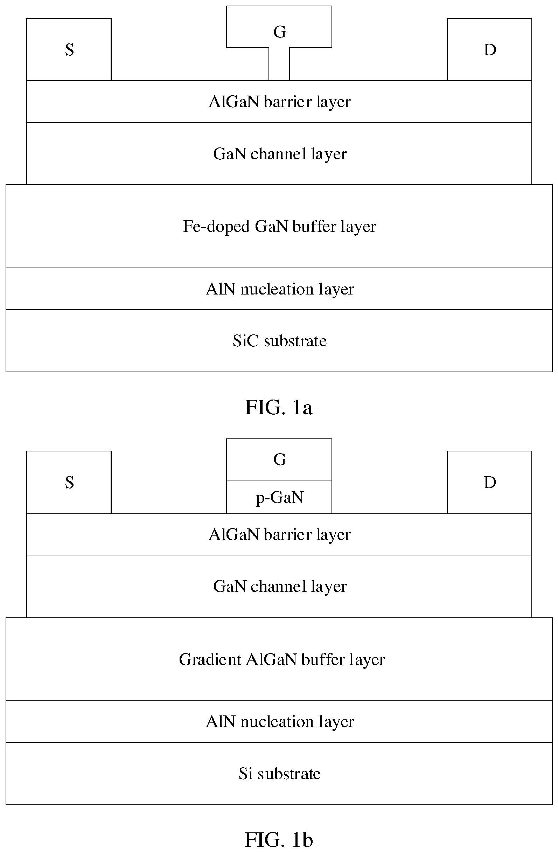

Refer to FIG. 1a. An HEMT device for radio frequency (RF) application, which currently is mainly a depletion-mode (D-Mode) HEMT device, usually uses semi-insulated SiC as a substrate. Then, an AlN material is epitaxially grown as a nucleation layer, and finally electrodes are manufactured, to obtain the RF HEMT device.

Refer to FIG. 1b. An HEMT device for power application mainly uses Si as a material of a substrate. A thick AlN material with a thickness of 50 nm to 300 nm is epitaxially grown on the basis of the Si material as a nucleation layer. Then, an AlGaN material is epitaxially grown as a buffer layer, or a superlattice of AlN/GaN is epitaxially grown as a buffer layer, to buffer a lattice mismatch and a thermal expansion coefficient mismatch between Si and a nitride. Then, the GaN material, the AlGaN material, and the like are epitaxially grown, and a layer of p-GaN is further manufactured on an AlGaN barrier layer to implement an enhancement-mode (E-mode) HEMT.

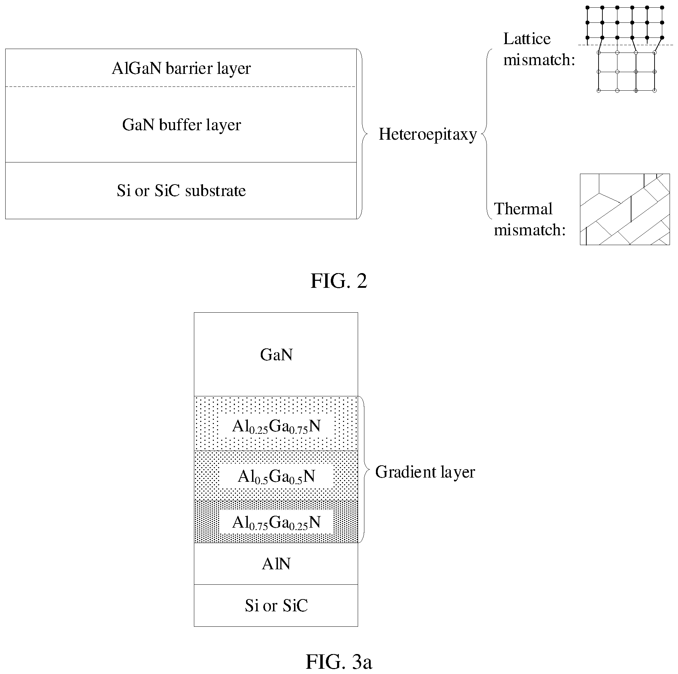

Refer to FIG. 2. All GaN HEMT devices that are currently mass produced use heterosubstrates, and a GaN material is heteroepitaxially grown by using a MOCVD method. An RF HEMT device usually uses semi-insulated SiC as a substrate. Because a lattice mismatch between SiC and GaN is about 3.5%, and a thermal mismatch between GaN and SiC is 33.1%, dislocation and epitaxial layer cracking problems may be caused. This dislocation defect and the like are also left in the device, and affect performance and long-term reliability of the device. An HEMT device for power application usually uses Si as a substrate. A lattice mismatch rate between GaN and Si reaches 16.9%, and a thermal expansion coefficient mismatch (namely, thermal mismatch) between GaN and Si reaches 56%. Therefore, epitaxial growth of GaN on the Si substrate and a heterostructure of GaN face severe challenges in terms of stress control and defect control.

A difference between lattice constants of epitaxial layer materials causes a high-density dislocation defect at an interface between the substrate and a GaN epitaxial layer. In an epitaxial growth process, most dislocations penetrate the epitaxial layer, which seriously affects crystalline quality of the epitaxial layer. In addition, because thermal expansion coefficients of the two layers are inconsistent, an internal stress of the entire epitaxial layer accumulates greatly in a cooling process after the epitaxial layer grows at a high temperature, and warping occurs and causes the epitaxial layer to crack. As a size of the substrate increases, the warping and cracking phenomenon becomes more and more obvious.

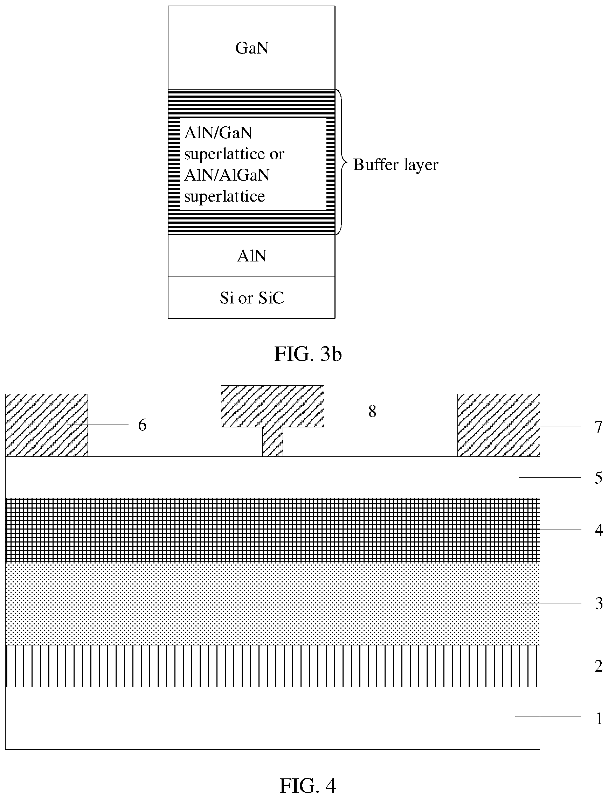

Currently, an insertion layer and the buffer layer are widely used to resolve a stress problem existing when GaN is heteroepitaxially grown on the substrate. For two mainstream stress adjustment solutions, refer to FIG. 3a and FIG. 3b. This epitaxial structure is complex, and requires an excessively thick buffer layer or gradient layer. In addition, a crack is easily generated on an edge of an epitaxially grown GaN layer, and the crack continuously extends to a center.

The foregoing challenge brings a great challenge to epitaxy. If a defective part can be detected, a usage area of the edge may be reduced. If the defective part is not detected or intercepted, a risk to device reliability may be caused after a device is manufactured. In addition, the foregoing challenge also brings a great challenge to epitaxy of a silicon substrate of 8 inches or even a larger silicon substrate of 12 inches or the like in the future.

Therefore, embodiments of this application provide an integrated circuit that can resolve the foregoing problem, a manufacturing method thereof, a power amplifier, and an electronic device. The following describes the integrated circuit, the manufacturing method thereof, the power amplifier, and the electronic device in detail with reference to specific accompanying drawings and embodiments.

Terms used in the following embodiments are merely intended to describe specific embodiments, but not to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise specifically emphasized in another manner. Terms "include", "comprise", "have", and variations thereof all mean "including but not limited to", unless otherwise specified.

FIG. 4 shows an example of a schematic diagram of a cross-sectional structure of an integrated circuit according to an embodiment of this application. Refer to FIG. 4. In this embodiment of this application, the integrated circuit may include: a substrate 1, a first nucleation layer 2 located on the substrate 1, a buffer layer 3 located on the first nucleation layer 2, a channel layer 4 located on the buffer layer 3, a barrier layer 5 located on the channel layer 4, and a source 6, a drain 7, and a gate 8 that are separately located on the barrier layer 5. A dislocation density of the buffer layer 3 is less than 1e8 cm⁻².

In the integrated circuit provided in this embodiment of this application, the dislocation density of the buffer layer 3 is less than 1e8 cm⁻², so that a higher-quality epitaxial growth material can be obtained, to improve device performance and long-term reliability of the integrated circuit.

Further, in this embodiment of this application, the dislocation density of the buffer layer 3 may be further controlled to be less than 1e6 cm⁻², so that crystalline quality can be further improved, and a higher-quality epitaxial growth material can be obtained, to improve device performance and long-term reliability of the integrated circuit.

In this embodiment of this application, a lattice mismatch between the first nucleation layer 2 and the buffer layer 3 may be controlled to be less than 2%, so that crystalline quality can be improved, and a higher-quality epitaxial growth material can be obtained, to improve device performance and long-term reliability of the integrated circuit.

Specifically, in this embodiment of this application, the integrated circuit may be a high electron mobility transistor (High Electron Mobility Transistor, HEMT).

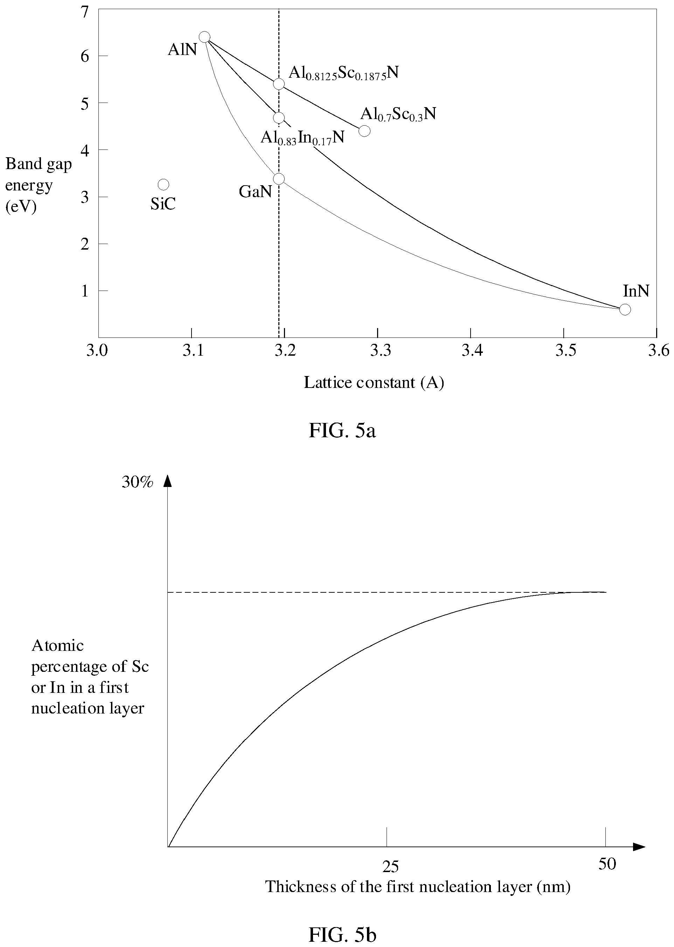

Specifically, in this embodiment of this application, the buffer layer 3 may include doped GaN or doped AlGaN, and the first nucleation layer 2 may include an AlScN material, an AlInN material, or the like. A doping material of the buffer layer 3 may be Fe, C, or the like, and resistivity of the buffer layer 3 may be improved by doping Fe or C. The following uses an example in which the buffer layer 3 uses the GaN material for description. FIG. 5a shows an example of a comparison diagram of lattice constants between different materials. Refer to FIG. 5a. A lattice constant of AlN is less than a lattice constant of GaN. In the conventional technology, AlN is used as a nucleation layer, and a lattice mismatch exists between AlN and GaN. A lattice dislocation exists in GaN that is epitaxially grown, which causes a lattice defect and affects crystalline quality. In this application, when the first nucleation layer 2 uses the AlScN material, Sc atoms in AlScN may increase an atomic spacing between Al and N, and increase a lattice constant, to implement a good lattice match with the GaN material and achieve a minimum lattice mismatch. Similarly, in this application, when the first nucleation layer 2 uses the AlInN material, In atoms in AlInN may increase an atomic spacing between Al and N, and increase a lattice constant, to implement a good lattice match with the GaN material and achieve a minimum lattice mismatch. In addition, specifically, a percentage of Sc or In in the material of the first nucleation layer 2 may be adjusted, to implement the good lattice match with the GaN material and achieve the minimum lattice mismatch.

Specifically, in this embodiment of this application, an atomic percentage of Sc or In in the first nucleation layer 2 is usually less than 40%, so that the lattice mismatch between the first nucleation layer 2 and the buffer layer 3 may be less than 2%. In addition, as the percentage of Sc or In in the first nucleation layer 2 gradually increases from 0%, a lattice mismatch with GaN gradually decreases. Further, in this embodiment of this application, the atomic percentage of Sc or In in the first nucleation layer 2 may range from 15% to 20%. Preferably, in this embodiment of this application, with reference to FIG. 5a, when the atomic percentage of Sc in the first nucleation layer 2 reaches 18.75%, that is, Al_{0.8125}Sc_{0.1875}N, a lattice of the AlScN material and a lattice of the GaN material completely match, and a mismatch between atoms is the smallest. When the atomic percentage of In in the first nucleation layer 2 reaches 17%, that is, Al_{0.83}In_{0.17}N, a lattice of the AlInN material and the lattice of the GaN material completely match, and a mismatch between atoms is the smallest.

In this embodiment of this application, when the first nucleation layer 2 is manufactured by using AlScN or AlInN, the first nucleation layer 2 may be specifically manufactured through a physical vapor deposition (physical vapor deposition, PVD) or pulsed laser deposition (Pulsed Laser Deposition, PLD) process. In comparison with a case in which AlN is manufactured as a nucleation layer through a MOCVD process, the first nucleation layer 2 manufactured through the PVD and PLD processes has less selectivity on the substrate 1, that is, a requirement on quality of the substrate 1 is reduced, so that growth of a material of the subsequent channel layer 4 does not depend on the substrate 1. The first nucleation layer 2 may be obtained through deposition on the slightly-poor-quality or ordinary-quality substrate 1 (which means that a defect requirement on a surface of the substrate 1 is not strict, and a macro-defect may be tolerated). The obtained first nucleation layer 2 may be used to directly grow the doped GaN material as the buffer layer 3, and then a high-quality GaN material may be epitaxially grown on the basis of the buffer layer 3 as the channel layer 4. Therefore, the substrate 1 may directly use a SiC or Si material, so that high-quality GaN epitaxial growth can also be implemented on the Si substrate with a large lattice mismatch.

Refer to FIG. 5a. In another embodiment of this application, when the substrate 1 uses the SiC material, in comparison with the case in which the first nucleation layer 2 uses the AlScN material, the AlInN material, or the like, a lattice constant of SiC is closer to a lattice constant of AlN. Therefore, atomic percentages of Sc or In at different locations in the first nucleation layer 2 may be adjusted, to be specific, an atomic percentage of Sc or In in a surface that is of the first nucleation layer 2 and that is in contact with the substrate 1 is adjusted to be less than an atomic percentage of Sc or In in a surface that is of the first nucleation layer 2 and that is in contact with the buffer layer 3, so that a lattice constant of the surface that is of the first nucleation layer 2 and that is in contact with the substrate 1 is less than a lattice constant of the surface that is of the first nucleation layer 2 and that is in contact with the buffer layer 3. In this way, the lattice constant of the surface that is of the first nucleation layer 2 and that is in contact with the substrate 1 is closer to the lattice constant of SiC, so that a lattice match in a contact interface between the first nucleation layer 2 and the substrate 1 is better; and the lattice constant of the surface that is of the first nucleation layer and that is in contact with the buffer layer 3 is closer to a lattice constant of the buffer layer 3, so that a lattice match in a contact interface between the first nucleation layer 2 and the buffer layer 3 is better, to reduce lattice defects of the first nucleation layer 2 and the buffer layer 3, and improve crystalline quality.

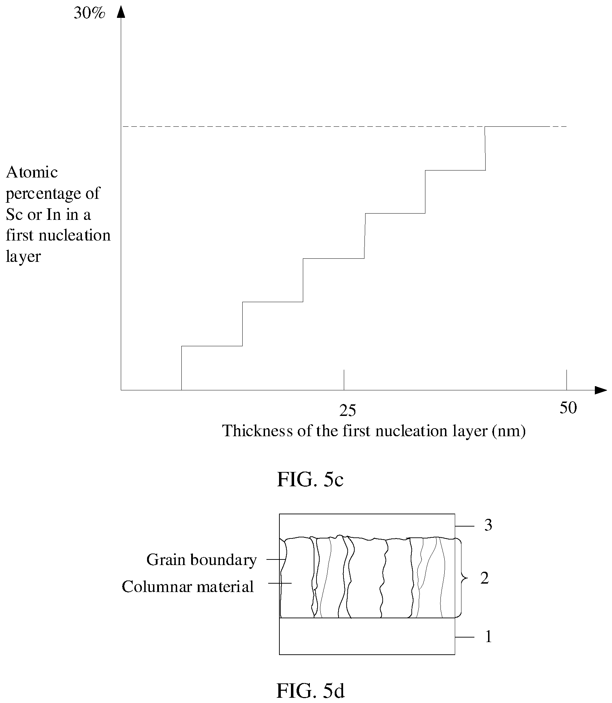

FIG. 5b and FIG. 5c show examples of schematic diagrams of relationships between a thickness of the first nucleation layer and the atomic percentage of Sc or In in the first nucleation layer. Refer to FIG. 5b and FIG. 5c. In this embodiment of this application, when the first nucleation layer 2 uses the AlScN material or the like, the atomic percentage of Sc in the first nucleation layer 2 may change from 0% to 18%, so that the first nucleation layer 2 is used as a gradient layer. A material of a surface that is of the gradient layer and that is in contact with the substrate 1 is AlN, to match a lattice of SiC most. An atomic percentage of Sc in the gradient layer gradually increases. The gradual increase may be understood as a plurality of increase trends, including a linear increase, a stepwise increase with reference to FIG. 5b, a parabolic increase with reference to FIG. 5c, and the like. An atomic percentage of Sc in AlScN on a surface that is of the gradient layer and that is in contact with the buffer layer 3 is the largest, to match the lattice of GaN. When the first nucleation layer 2 uses the AlInN material or the like, the atomic percentage of In in the first nucleation layer 2 may change from 0% to 17%, so that the first nucleation layer 2 is used as a gradient layer. A material of a surface that is of the gradient layer and that is in contact with the substrate 1 is AlN, to match a lattice of SiC most. An atomic percentage of In in the gradient layer gradually increases. The gradual increase may be understood as a plurality of increase trends, including a linear increase, a stepwise increase with reference to FIG. 5b, a parabolic increase with reference to FIG. 5c, and the like. An atomic percentage of In in AlInN on a surface that is of the gradient layer and that is in contact with the buffer layer 3 is the largest, to match the lattice of GaN.

In this embodiment of this application, compared with using the MOCVD process to manufacture the first nucleation layer 2, using the PVD or PLD process to manufacture the first nucleation layer 2 leads to a high deposition rate during generation of the first nucleation layer 2, which can save more than 20% production capacity, and significantly reduce production costs. In addition, the PVD or PLD process may support a substrate of 8 inches to 12 inches or more. Specifically, direct sputtering may be performed by using an AlScN or AlInN target, or reactive sputtering may be performed by using an Al target, an Sc target (or an In target), and an ammonia gas or a nitrogen gas, to form the first nucleation layer 2 on the substrate 1. The atomic percentage of Sc or In in the first nucleation layer 2 formed through the foregoing process may be fixed. Alternatively, when the Al target, the Sc target (or the In target), and the ammonia gas or the nitrogen gas are used to perform reactive sputtering to form the first nucleation layer 2 on the substrate 1, a reactive sputtering proportion of the Sc target or the In target may be gradually increased, to gradually increase the atomic percentage of Sc or In in the first nucleation layer 2 in a direction from the substrate 1 to the buffer layer 3, to form the gradient layer. The thick first nucleation layer 2 may be manufactured through the PVD or PLD process, and the thickness of the first nucleation layer 2 may be controlled within 10 nm to 500 nm.

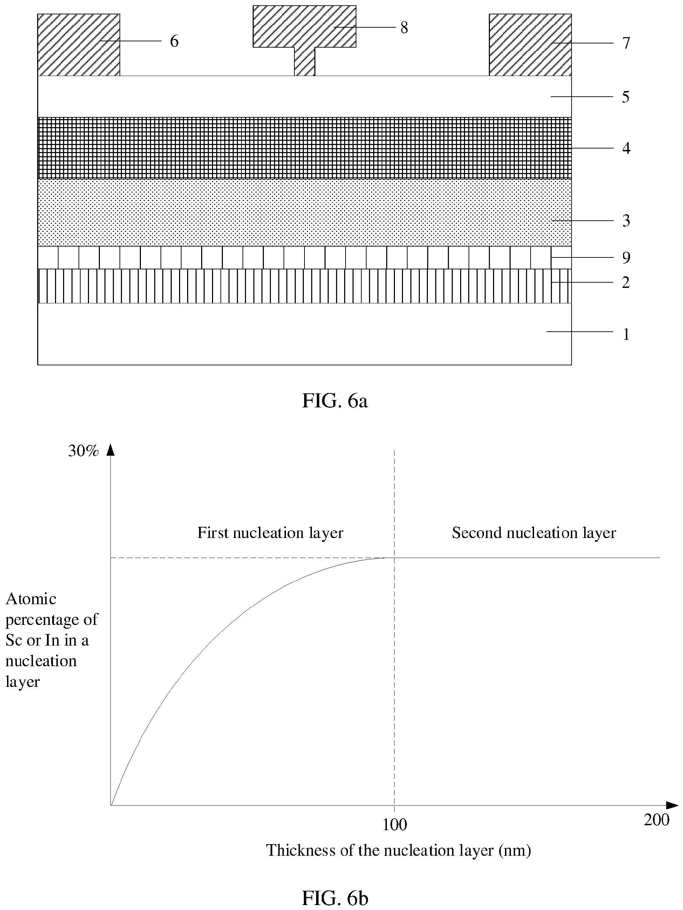

FIG. 5d shows an example of a schematic diagram of a structure of the first nucleation layer made of a polycrystalline material. Refer to FIG. 5d. Because the first nucleation layer 2 manufactured through PVD or PLD is made of the polycrystalline material (where the polycrystalline material is made of a plurality of columnar materials, there is a grain boundary between the columnar materials, and the grain boundary forms a defect), the first nucleation layer 2 has a large quantity of grain boundaries, crystalline quality is poor, and crystals are mainly arranged in a vertical direction. Therefore, to improve crystalline quality of the nucleation layer, after the first nucleation layer 2 is manufactured through the PVD or PLD process, a high temperature annealing process may be performed on the first nucleation layer 2 under protection of an inert gas, to improve crystalline quality of the material of the first nucleation layer 2. Alternatively, to improve crystalline quality of the nucleation layer, after the first nucleation layer 2 is manufactured through the PVD or PLD process, a second nucleation layer may be manufactured through the MOVCD process. The second nucleation layer may be made of a quasi-single crystalline material. FIG. 6a shows an example of a schematic diagram of a cross-sectional structure of another integrated circuit according to an embodiment of this application. Refer to FIG. 6a. In another embodiment of this application, the integrated circuit may further include a second nucleation layer 9 located between a first nucleation layer 2 and a buffer layer 3. The second nucleation layer 9 is manufactured through a MOCVD process, so that a quantity of grain boundaries in the second nucleation layer 9 is less than a quantity of grain boundaries in the first nucleation layer. In other words, the second nucleation layer 9 has fewer crystal defects, and crystalline quality is better. In this way, when the buffer layer 3 is epitaxially grown on the second nucleation layer 9, better crystalline quality can be obtained.

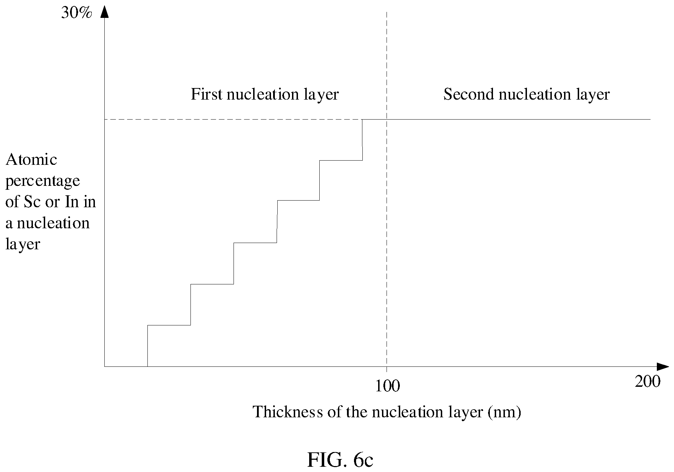

FIG. 6b and FIG. 6c show examples of schematic diagrams of relationships between a thickness of a nucleation layer and an atomic percentage of Sc or In in the nucleation layer. It is worth noting that, to ensure that the second nucleation layer 9 with good crystalline quality can be obtained, a material used by the second nucleation layer 9 needs to be the same as a material used by the first nucleation layer 1. For example, after AlScN is deposited on a substrate 1 as the first nucleation layer 2 through a PVD or PLD process, AlScN may continue to be grown as the second nucleation layer 9 through the MOCVD process. In addition, atomic percentages of Sc or In in surfaces that are of the first nucleation layer 2 and the second nucleation layer 9 and that are in contact with each other are preferably the same, so that lattices of the first nucleation layer 2 and the second nucleation layer 9 completely match, and no new lattice defect appears. For example, if an atomic percentage of Sc in the first nucleation layer 2 is 18%, an atomic percentage of Sc in the second nucleation layer 9 is also 18%. For another example, refer to FIG. 6b and FIG. 6c. If the atomic percentage of Sc in the first nucleation layer 2 changes from 0% to 18%, the atomic percentage of Sc in the second nucleation layer 9 is 18%. In addition, because a film layer is slowly grown when the MOVCD process is used, a thickness of the second nucleation layer 9 may be thin, and is controlled to be less than 100 nm, to be specific, from several nm to dozens of nm.

In this embodiment of this application, a channel layer 4 may include a GaN material. The buffer layer 3, the channel layer 4, and a barrier layer 5 may all be manufactured through the MOCVD process, to obtain a single crystalline material. Thicknesses of the buffer layer 3 and the channel layer 4 may be less than 5 µm.

In this embodiment of this application, a surface density of a two-dimensional electron gas that may be formed by using the barrier layer 5 is greater than 1e13 cm⁻², to implement a higher surface density of the two-dimensional electron gas when a thickness of the barrier layer 5 is thin, and facilitate application of a radio frequency HEMT device at a high frequency. Further, the surface density of the two-dimensional electron gas that may be formed by using the barrier layer 5 is greater than 2e13 cm⁻², to further improve the surface density of the two-dimensional electron gas of the barrier layer 5.

In this embodiment of this application, the barrier layer 5 may include the AlScN material, an AlInN material, an AlN material, or the like. These materials have good piezoelectric effect, so that a two-dimensional electron gas concentration of the barrier layer 5 can be increased, and device short channel effect that is in a device and that is caused by a decrease in the thickness of the barrier layer 5 can be effectively reduced. In addition, the AlScN or AlInN material is used as the barrier layer 5, so that a lattice mismatch between the channel layer 4 and the barrier layer 5 can be further reduced, crystalline quality can be improved, and a higher-quality epitaxial growth material can be obtained, to improve device performance and long-term reliability of the integrated circuit. Specifically, when the AlScN or AlInN material is used as the barrier layer 5, an atomic percentage of Sc or In is the same as the atomic percentage of Sc or In in the first nucleation layer. The atomic percentage is usually less than 40%, and preferably ranges from 15% to 20%, to reduce the lattice mismatch. An optimal atomic percentage of Sc is 18%, and an optimal atomic percentage of In is 17%.

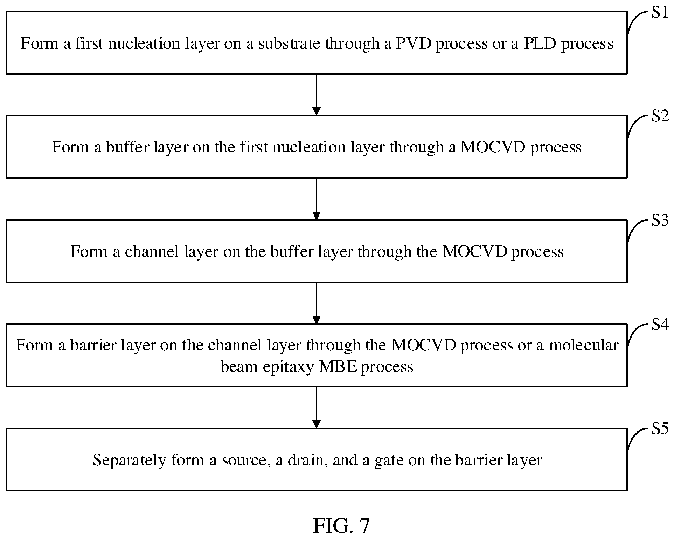

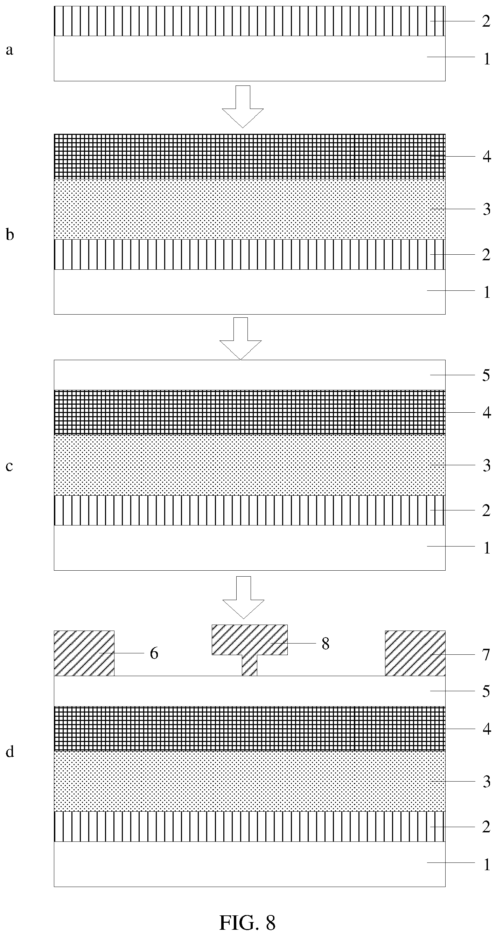

To facilitate understanding of the integrated circuit provided in embodiments of this application, the following describes in detail a manufacturing method thereof with reference to the accompanying drawings. FIG. 7 shows an example of a schematic flowchart of a manufacturing method for an integrated circuit according to an embodiment of this application. FIG. 8 shows an example of a schematic diagram of a structure after each step in the manufacturing method provided in FIG. 7 is completed. Refer to FIG. 7 and FIG. 8. The integrated circuit may be manufactured by using the following manufacturing method, and the method includes the following steps:

S1: Form a first nucleation layer 2 on a substrate 1 through a PVD process or a PLD process. Refer to a in FIG. 8.

In comparison with a case in which AlN is manufactured as a nucleation layer through a MOCVD process, the first nucleation layer 2 manufactured through the PVD and PLD processes has less selectivity on the substrate 1, that is, a requirement on quality of the substrate 1 is reduced, so that growth of a material of a subsequent channel layer 4 does not depend on the substrate 1. The first nucleation layer 2 may be obtained through deposition on the slightly-poor-quality or ordinary-quality substrate 1. The obtained first nucleation layer 2 may be used to directly grow a doped GaN material as a buffer layer 3, and then a high-quality GaN material may be epitaxially grown on the basis of the buffer layer 3 as the channel layer 4. Therefore, the substrate 1 may directly use a SiC or Si material, so that high-quality GaN epitaxial growth can also be implemented on the Si substrate with a large lattice mismatch.

In addition, compared with using the MOCVD process to manufacture the first nucleation layer 2, using the PVD or PLD process to manufacture the first nucleation layer 2 leads to a high deposition rate during generation of the first nucleation layer 2, which can save more than 20% production capacity, and significantly reduce production costs. In addition, the PVD or PLD process may support a substrate of 8 inches to 12 inches or more.

Specifically, direct sputtering may be performed by using an AlScN or AlInN target, or reactive sputtering may be performed by using an Al target, an Sc target (or an In target), and an ammonia gas or a nitrogen gas, to form the first nucleation layer 2 on the substrate 1. An atomic percentage of Sc or In in the first nucleation layer 2 formed through the foregoing process may be fixed. Alternatively, when the Al target, the Sc target (or the In target), and the ammonia gas or the nitrogen gas are used to perform reactive sputtering to form the first nucleation layer 2 on the substrate 1, a reactive sputtering proportion of the Sc target or the In target may be gradually increased, to gradually increase the atomic percentage of Sc or In in the first nucleation layer 2 in a direction from the substrate 1 to the buffer layer 3, to form a gradient layer. The thick first nucleation layer 2 may be manufactured through the PVD or PLD process, and a thickness of the first nucleation layer 2 may be controlled within 10 nm to 500 nm.

S2: Form the buffer layer 3 on the first nucleation layer 2 through the MOCVD process. Refer to b in FIG. 8.

Specifically, doped GaN or doped AlGaN may be selected to form the buffer layer 3. A doping material of the buffer layer 3 may be Fe, C, or the like, and resistivity of the buffer layer 3 may be improved by doping Fe or C. A lattice of the material of the first nucleation layer 2 matches a lattice of the material of the buffer layer 3, so that a dislocation defect and the like of the buffer layer 3 grown on the first nucleation layer 2 can be reduced, crystalline quality can be improved, and a higher-quality epitaxial growth material can be obtained, to improve device performance and long-term reliability of the integrated circuit. Specifically, a thickness of the buffer layer 3 manufactured through MOCVD may be controlled to be less than 5 µm.

S3: Form the channel layer 4 on the buffer layer 3 through the MOCVD process. Refer to b in FIG. 8.

Specifically, the GaN material may be selected to form the channel layer 4. A thickness of the channel layer 4 manufactured through MOCVD may be controlled to be less than 5 µm.

S4: Form a barrier layer 5 on the channel layer 4 through the MOCVD process or a molecular beam epitaxy (molecular beam epitaxy, MBE) process. Refer to c in FIG. 8.

Specifically, the AlScN material, the AlInN material, the AlN material, or the like may be selected to form the barrier layer 5. These materials have good piezoelectric effect, so that a two-dimensional electron gas concentration of the barrier layer 5 can be increased, and device short channel effect that is in a device and that is caused by a decrease in a thickness of the barrier layer 5 can be effectively reduced. In addition, the AlScN or AlInN material is used as the barrier layer 5, so that a lattice mismatch between the channel layer 4 and the barrier layer 5 can be further reduced, crystalline quality can be improved, and a higher-quality epitaxial growth material can be obtained, to improve device performance and long-term reliability of the integrated circuit.

S5: Separately form a source 6, a drain 7, and a gate 8 on the barrier layer 5. Refer to d in FIG. 8.

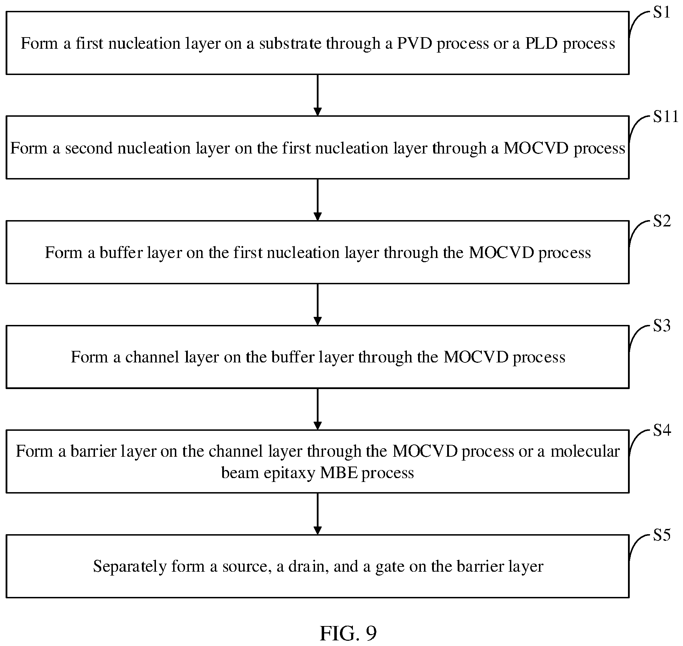

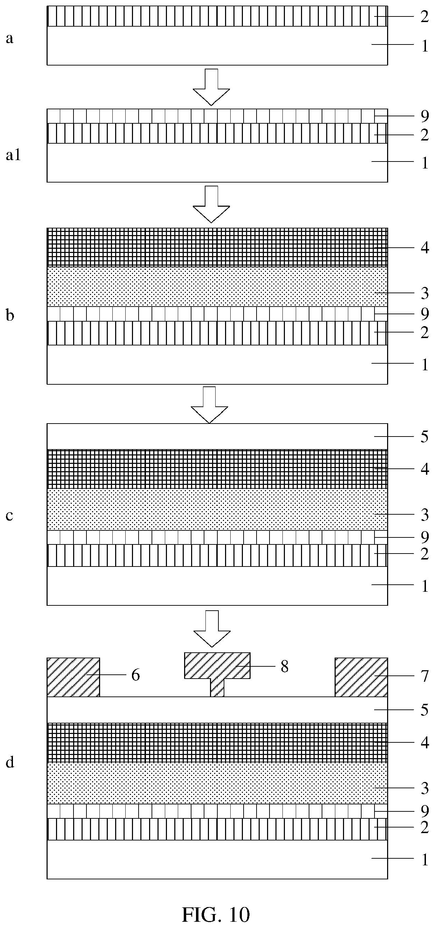

FIG. 9 shows an example of a schematic flowchart of another manufacturing method for an integrated circuit according to an embodiment of this application. FIG. 10 shows an example of a schematic diagram of a structure after each step in the manufacturing method provided in FIG. 9 is completed. Refer to FIG. 9 and FIG. 10. In another manufacturing method provided in this application, after step S1 of forming a first nucleation layer on a substrate, the method may further include S11: Form a second nucleation layer on the first nucleation layer through a MOCVD process. Refer to a1 in FIG. 10.

Because the first nucleation layer 2 manufactured through PVD or PLD is made of a polycrystalline material, the first nucleation layer 2 has a large quantity of grain boundaries, crystalline quality is poor, and crystals are mainly arranged in a vertical direction. Therefore, to improve crystalline quality of the nucleation layer, after the first nucleation layer 2 is manufactured through a PVD or PLD process, the second nucleation layer 9 may be manufactured through the MOVCD process. The second nucleation layer 9 may be made of a quasi-single crystalline material. A quantity of grain boundaries in the second nucleation layer 9 is less than a quantity of grain boundaries in the first nucleation layer. In other words, the second nucleation layer 9 has fewer crystal defects, and crystalline quality is better. In this way, when a buffer layer 3 is epitaxially grown on the second nucleation layer 9, better crystalline quality can be obtained.

It is worth noting that, to ensure that the second nucleation layer 9 with good crystalline quality can be obtained, a material used by the second nucleation layer 9 needs to be the same as a material used by the first nucleation layer 1. For example, after AlScN is deposited on the substrate 1 as the first nucleation layer 2 through the PVD or PLD process, AlScN may continue to be grown as the second nucleation layer 9 through the MOCVD process. In addition, atomic percentages of Sc or In in surfaces that are of the first nucleation layer 2 and the second nucleation layer 9 and that are in contact with each other are preferably the same, so that lattices of the first nucleation layer 2 and the second nucleation layer 9 completely match, and no new lattice defect appears. For example, if an atomic percentage of Sc in the first nucleation layer 2 is 18%, an atomic percentage of Sc in the second nucleation layer 9 is also 18%. For another example, if the atomic percentage of Sc in the first nucleation layer 2 gradually transits from 0% to 18%, the atomic percentage of Sc in the second nucleation layer 9 is 18%. In addition, because a film layer is slowly grown when the MOVCD process is used, a thickness of the second nucleation layer 9 may be thin, and is controlled to be less than 100 nm, to be specific, from several nm to dozens of nm.

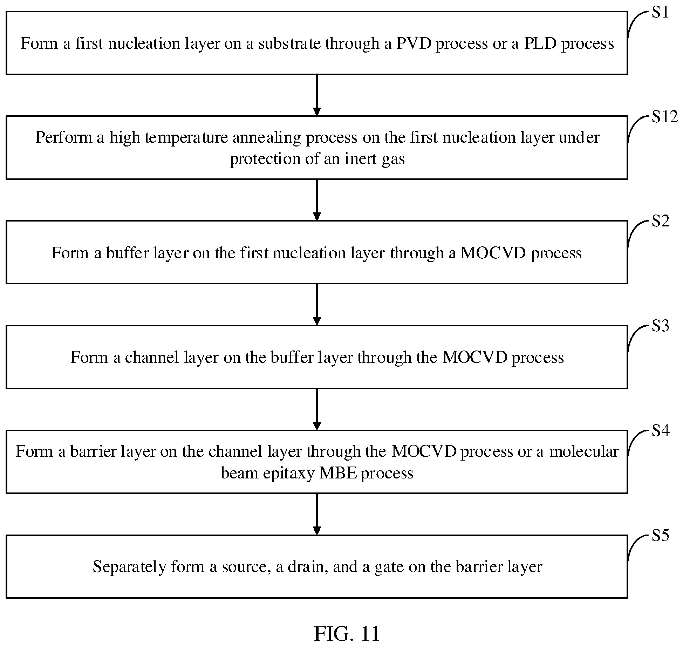

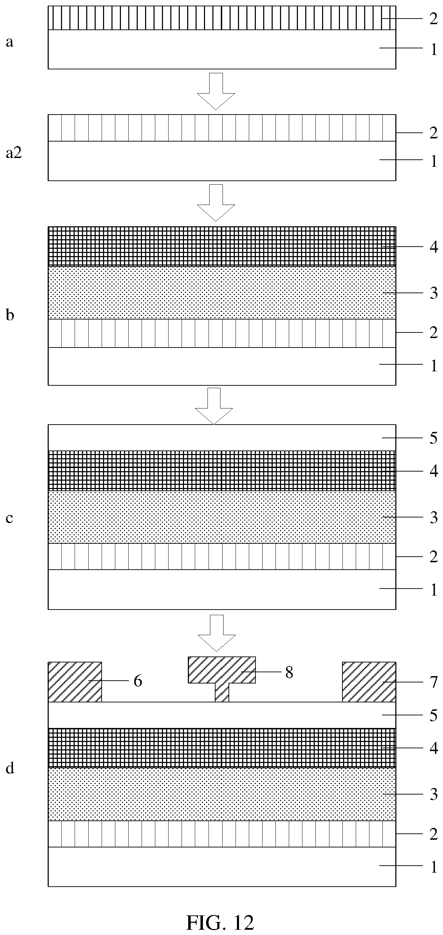

FIG. 11 shows an example of a schematic flowchart of another manufacturing method for an integrated circuit according to an embodiment of this application. FIG. 12 shows an example of a schematic diagram of a structure after each step in the manufacturing method provided in FIG. 11 is completed. In an optional solution, refer to FIG. 11 and FIG. 12. After step S1 of forming a first nucleation layer on a substrate, the method may further include S12: A high temperature annealing process is performed on a first nucleation layer 2 under protection of an inert gas, to improve crystalline quality of a material of the first nucleation layer 2. Refer to a2 in FIG. 12.

Specifically, an annealing temperature may be controlled within 1500 degrees to 1900 degrees, and preferably, the annealing temperature is controlled within 1600 degrees to 1800 degrees. Annealing duration is within 1 hour to 5 hours, and preferably within 2 hours to 3 hours. The inert gas may be specifically an argon gas or the nitrogen gas.

An embodiment of this application further provides an electronic device. The electronic device may include a circuit board and any integrated circuit provided in the foregoing embodiments of this application. The integrated circuit is disposed on the circuit board. A problem solving principle of the electronic device is similar to that of the foregoing integrated circuit. Therefore, for implementation of the electronic device, refer to the implementation of the foregoing integrated circuit, and details are not described again.

An embodiment of this application further provides a power amplifier. The power amplifier may include a circuit board and any integrated circuit provided in the foregoing embodiments of this application. The integrated circuit is disposed on the circuit board. A problem solving principle of the power amplifier is similar to that of the foregoing integrated circuit. Therefore, for implementation of the power amplifier, refer to the implementation of the foregoing integrated circuit, and details are not described again.

Apparently, a person skilled in the art can make various modifications and variations to this application without departing from the scope of this application. This application is intended to cover these modifications and variations of this application provided that they fall within the scope of the claims of this application and an equivalent technology thereof.

## Claims

1. An integrated circuit, comprising:
a substrate;
a first nucleation layer, located on the substrate;
a buffer layer, located on the first nucleation layer;
a channel layer, located on the buffer layer;
a barrier layer, located on the channel layer; and
a source, a drain, and a gate, separately located on the barrier layer, wherein
a dislocation density of the buffer layer is less than 1e8 cm⁻².

2. The integrated circuit according to claim 1, wherein the dislocation density of the buffer layer is less than 1e6 cm⁻².

3. The integrated circuit according to claim 1, wherein a lattice mismatch between the first nucleation layer and the buffer layer is less than 2%.

4. The integrated circuit according to any one of claims 1 to 3, wherein the buffer layer comprises doped GaN or doped AlGaN, and the first nucleation layer comprises AlScN or AlInN.

5. The integrated circuit according to claim 4, wherein an atomic percentage of Sc or In in the first nucleation layer is less than 40%.

6. The integrated circuit according to claim 5, wherein the atomic percentage of Sc or In in the first nucleation layer ranges from 15% to 20%.

7. The integrated circuit according to claim 6, wherein the atomic percentage of Sc in the first nucleation layer is 18.75%, or the atomic percentage of In in the first nucleation layer is 17%.

8. The integrated circuit according to claim 4, wherein an atomic percentage of Sc or In in a surface that is of the first nucleation layer and that is in contact with the substrate is less than an atomic percentage of Sc or In in a surface that is of the first nucleation layer and that is in contact with the buffer layer.

9. The integrated circuit according to claim 8, wherein an atomic percentage of Sc in the first nucleation layer changes from 0% to 18%; or an atomic percentage of In in the first nucleation layer changes from 0% to 17%.

10. The integrated circuit according to any one of claims 1 to 9, further comprising: a second nucleation layer located between the first nucleation layer and the buffer layer, wherein a quantity of grain boundaries in the second nucleation layer is less than a quantity of grain boundaries in the first nucleation layer.

11. The integrated circuit according to any one of claims 1 to 10, wherein a surface density of a two-dimensional electron gas formed by using the barrier layer is greater than 1e13 cm⁻².

12. The integrated circuit according to claim 11, wherein the surface density of the two-dimensional electron gas formed by using the barrier layer is greater than 2e13 cm⁻².

13. The integrated circuit according to claim 11 or 12, wherein the channel layer comprises GaN, and the barrier layer comprises AlScN, AlInN, or AlN.

14. The integrated circuit according to any one of claims 1 to 13, wherein the substrate comprises Si or SiC.

15. The integrated circuit according to any one of claims 1 to 14, wherein the integrated circuit is a high electron mobility transistor.

16. A manufacturing method for the integrated circuit according to any one of claims 1 to 15, comprising:
forming a first nucleation layer on a substrate through a physical vapor deposition PVD process or a pulsed laser deposition PLD process;
forming a buffer layer on the first nucleation layer through a metal organic chemical vapor deposition MOCVD process;
forming a channel layer on the buffer layer through the MOCVD process;
forming a barrier layer on the channel layer through the MOCVD process or a molecular beam epitaxy MBE process; and
separately forming a source, a drain, and a gate on the barrier layer.

17. The manufacturing method according to claim 16, wherein after the forming a first nucleation layer on a substrate, the method further comprises:
forming a second nucleation layer on the first nucleation layer through the MOCVD process.

18. The manufacturing method according to claim 16, wherein after the forming a first nucleation layer on a substrate, the method further comprises:
performing a high temperature annealing process on the first nucleation layer under protection of an inert gas.

19. The manufacturing method according to any one of claims 16 to 18, wherein the forming a first nucleation layer on a substrate specifically comprises:
performing direct sputtering by using an AlScN or AlInN target, performing reactive sputtering by using an Al target, an Sc target, and an ammonia gas or a nitrogen gas, or performing reactive sputtering by using an Al target, an In target, and an ammonia gas or a nitrogen gas, to form the first nucleation layer on the substrate.

20. The manufacturing method according to claim 19, wherein when the Al target, the Sc target, and the ammonia gas or the nitrogen gas are used to perform reactive sputtering, or the Al target, the In target, and the ammonia gas or the nitrogen gas are used to perform reactive sputtering to form the first nucleation layer on the substrate, a reactive sputtering proportion of the Sc target or the In target is gradually increased, to gradually increase an atomic percentage of Sc or In in the first nucleation layer in a direction from the substrate to the buffer layer.

21. An electronic device, comprising a circuit board and the integrated circuit according to any one of claims 1 to 15 that is disposed on the circuit board.

22. A power amplifier, comprising a circuit board and the integrated circuit according to any one of claims 1 to 15 that is disposed on the circuit board.
